# EUROPEAN PATENT APPLICATION

(11) **EP 2 184 856 A2**
(43) Date of publication of application: **12.05.2010**
(21) Application number: 09174952.3
(22) Date of filing: 03.11.2009
(51) Int. Cl.: H03K 17/96

(54) **Home appliance and washing machine**

(30) Priority: 05.11.2008 KR 20080109545; 06.11.2008 US 112067 P
(71) Applicant: LG Electronics Inc., Seoul 150-721 (KR)
(72) Inventor: Jung, Hye Sun, 641-110, Kyungsangnam-do (KR); Jung, Tae Young, 641-110, Kyungsangnam-do (KR)
(74) Representative: Loisel, Bertrand

(57) **Abstract**

A home appliance and a washing machine are provided. The home appliance includes a touch pad unit having a sensor to sense an external capacitance variation, a photo-etched member coupled to the touch pad unit and having a touch pad hole corresponding to the sensor, the photo-etched member having a pattern realized by photo-etching, and a transparent member coupled to the photo-etched member so as to define an external appearance of the photo-etched member and having an indicator to inform a user of a touch region, the indicator having an area smaller than that of the touch pad hole so as to be located in an interior region of the touch pad hole. The above described configuration advantageously prevents malfunction of the touch pad unit.

## Description

The present application claims priority to Korean Application No. 10-2008-0109545 filed in Korea on November 5, 2008, and US Patent Application no. 61/112,067 filed on November 6, 2008 in US, the entire contents of which are hereby incorporated by reference in their entirety.

### BACKGROUND OF THE INVENTION

### 1.Field of the Invention

The present invention relates to a home appliance and a washing machine, and more particularly, to a home appliance and a washing machine of an improved recognition accuracy of a touch signal.

### 2. Discussion of the Related Art

Generally, home appliances refer to apparatuses for performing housework using energy, and washing machines refer to apparatuses for washing or drying an object. Examples of home appliances include a microwave oven, cleaner, laundry treating machine, drier, and dish washer. Examples of washing machines include a laundry treating machine, drier, and dish washer. All the home appliances and washing machines are generally printed, at an external appearance thereof, with various designs of patterns to stimulate the customers' interest. These patterns have been conventionally formed using silk screen printing, etc. After completely silk screen printing a pattern on a home appliance or a washing machine, a transparent member has been affixed to the entire surface of the pattern, to aid realization of the pattern.

### SUMMARY OF THE INVENTION

An object of the present invention is to provide a home appliance and a washing machine capable of preventing malfunction of a touch pad unit.

The objects of the present invention are not limited to the above-mentioned object and other objects that have not mentioned above will become evident to those skilled in the art from the following description.

To achieve the above objects, there is provided a home appliance according to an exemplary embodiment of the present invention, including a touch pad unit having a sensor to sense an external capacitance variation, a photo-etched member coupled to the touch pad unit and having a touch pad hole corresponding to the sensor, the photo-etched member having a pattern realized by photo-etching, and a transparent member coupled to the photo-etched member so as to define an external appearance of the photo-etched member and having an indicator to inform a user of a touch region, the indicator having an area smaller than that of the touch pad hole so as to be located in an interior region of the touch pad hole.

To achieve the above objects, there is provided a washing machine according to another exemplary embodiment of the present invention, including a touch pad unit having a sensor to sense an external capacitance variation, a photo-etched member coupled to the touch pad unit and having a touch pad hole corresponding to the sensor, the photo-etched member having a pattern realized by photo-etching, and a transparent member coupled to the photo-etched member so as to define an external appearance of the photo-etched member and having an indicator to inform a user of a touch region, the indicator having an area smaller than that of the touch pad hole so as to be located in an interior region of the touch pad hole.

### BRIEF DESCRIPTION OF THE DRAWINGS

FIG. 1 is a perspective view showing a laundry treating machine according to an embodiment of the present invention;
FIG. 2 is an enlarged perspective view of the partially cut-way portion A shown in FIG. 1;
FIG. 3 is a sectional view showing a configuration of a pattern unit;
FIG. 4 is a front view showing a control panel shown in FIG. 1;
FIG. 5 is an exploded perspective view showing an assembly sequence of a touch pad unit and the pattern unit of the control panel;
FIG. 6 is a sectional view showing a coupling relationship between the touch pad unit and the pattern unit;
FIG. 7 is a sectional view showing one embodiment of a sensor shown in FIG. 6; and
FIG. 8 is a perspective view showing another embodiment of the sensor shown in FIG. 6.

### DETAILED DESCRIPTION OF THE PREFERRED EMBODIMENTS

The advantages and features of the present invention, and the way of attaining them, will become apparent with reference to embodiments described below in conjunction with the accompanying drawings. However, the present invention is not limited to the embodiments disclosed below and will be embodied in a variety of different forms; rather, these embodiments are provided so that this disclosure will be thorough and complete, and will fully convey the scope of the present invention to those skilled in the art, and the scope of the present invention will be defined by the appended claims. Like reference numerals refer to like elements throughout the specification.

A home appliance of the present invention refers to an electric appliance used at home, such as a laundry treating machine, refrigerator, television, or the like. In particular, a washing machine is designed to wash an object via washing, rinsing, spin-drying, drying operations, or the like. Based on the kind of an object to be washed, for example, washing machines may be classified into various kinds including a laundry treating machine and a dish washing machine. The laundry treating machine may include a washer, a dryer, a combined washing/drying machine, a spin-drier, and the like.

Although the following embodiments of the present invention describe a laundry treating machine falling under the category of a washing machine, the present invention is not limited thereto and is applicable to a variety of washing machines. Furthermore, it is noted that the present invention is applicable to a variety of home appliances.

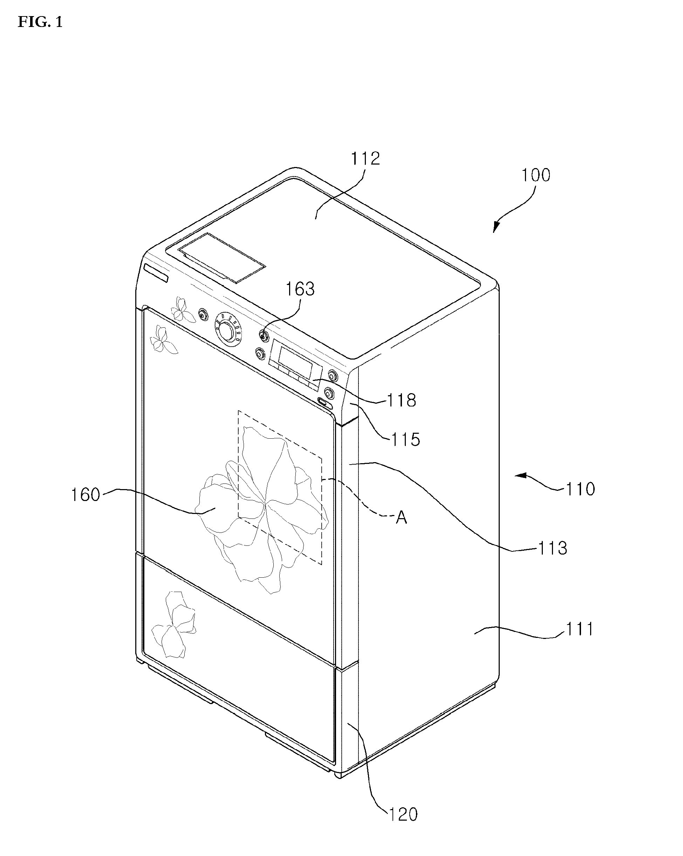

FIG. 1 is a perspective view showing a laundry treating machine according to an embodiment of the present invention.

Referring to FIG. 1, the laundry treating machine 1 includes a cabinet 110, a tub (not shown) arranged in the cabinet 110 to store wash water introduced from an external source, a drum (not shown) rotatably arranged in the tub to receive laundry therein, a drive device (not shown) to drive the drum so as to transmit rotating force, a wash water supply device (not shown) to supply wash water from an external source at the outside of the cabinet 110, and a drain device (not shown) to discharge the wash water stored in the tub to the outside.

The cabinet 110 includes a cabinet body 111, a control panel 115, and a top plate 112 coupled to an upper side of the cabinet body 111.

A shape defining part of a home appliance, called a body, case, cabinet, or the like, (hereinafter, referred to as a "casing member") is generally fabricated through injection molding. It is noted that the casing member does not essentially take the form of a single body to realize a shape of the home appliance, and may include a plurality of casing members, such as, e.g., a casing member, a door casing member, and a receptacle casing member, which are coupled to each other so as to realize the overall shape of the home appliance.

A pattern unit 160 is coupled to a predetermined portion of the casing member 110 to arouse a user's aesthetic appreciation. The pattern unit 160 may be coupled to the casing member by use of an adhesive member, such as a sealant or a double-sided tape. The pattern unit 160 is formed with various patterns of images to arouse a user's aesthetic appreciation. A configuration for formation of images will be described hereinafter.

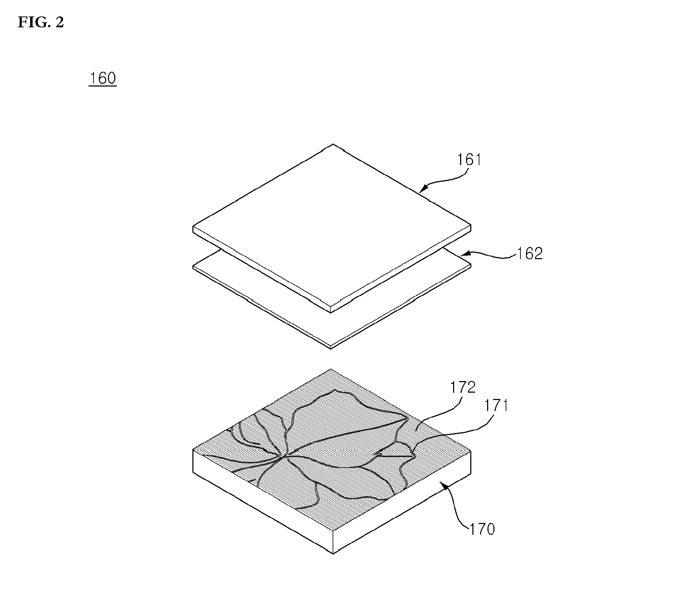

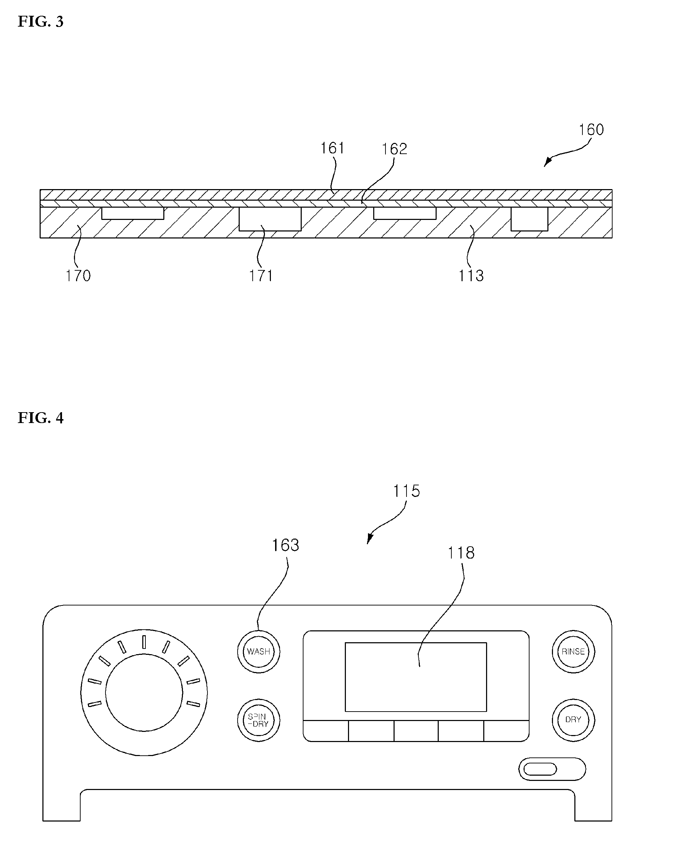

FIG. 2 is an enlarged perspective view of the partially cut-way portion A shown in FIG. 1, and FIG. 3 is a sectional view showing a configuration of the pattern unit.

Referring to FIGs. 2 and 3, the pattern unit 160 is coupled to an outer surface of a casing member 113 to decorate an external appearance of the casing member 113. The pattern unit 160 includes a transparent member 161, a photo-etched member 170 formed with a pattern by photo-etching, and an adhesive member 162 provided between the transparent member 161 and the photo-etched member 170 to couple the transparent member 161 and the photo-etched member 170 to each other.

Here, photo-etching is an ultra-precision processing technology and includes coating a photo-resist film on a metal surface, exposing and developing a partial image by ultraviolet light, and then, etching the exposed metal surface. In more detail, photo-etching is a combination of photolithography and etching. Photolithography includes applying a photo-resist solution over a substrate to form a photo-resist film, and selectively exposing and developing a partial image on the film by ultraviolet light having passed through a photo-mask (i.e. a patterned film). Etching is a technology for selectively etching a material surface using a developed photo-resist film as a protective film. Specifically, etching is one kind of a recess forming technology for perforating and cutting a recess in a metal surface where no protective film is present via electrolytic etching or chemical etching using an acid or alkali solution, ferric chloride solution, or the like. Finally, a finishing process for removing the protective film using an alkali solution, organic solvent, or the like may be added. Accordingly, a surface of the photo-etched member 170 is formed with the pattern by etching.

The photo-etched member 170 includes a lined portion 172 on which hair lines are formed by a predetermined interval, and a patterned portion 171 on which the pattern is formed by photo-etching.

The lined portion 172 may be realized by a processing device that uses an abrasive sheet formed with appropriate sizes of particles. As the abrasive sheet is rotated at a high speed, the lined portion 172 of discontinuous pitches may be formed on the surface of the ornament 100.

The lined portion 172 serves to enhance material texture of the photo-etched member 170. In particular, when the photo-etched member 170 is made of a metal, such as stainless steel (STS), the lined portion 172 has the effects of improving high gloss that is peculiar to a metal, preventing glare via scattered reflection of indoor light, and creating a luxurious external appearance.

The lined portion 172 may be formed at a partial region of a surface, or the entire surface of the photo-etched member 170. The patterned portion 171 may be formed at the surface of the photo-etched member 170 in a state wherein the lined portion 172 has been formed. The lined portion 172 and the patterned portion 171 may be formed so as not to overlap each other.

The transparent member 161 is made of various transparent materials, to allow the photo-etched member 170 to be seen from the outside. In one example, the transparent member 161 may be made of reinforced glass. The adhesive member 162 is inserted between the transparent member 161 and the photo-etched member 170 to attach the transparent member 161 and the photo-etched member 170 to each other. The adhesive member 162 may take the form of a desired adhesive film to closely attach the transparent member 161 and the photo-etched member 170 to each other. In one example, the adhesive film may include Pressure Sensitive Adhesive (PSA).

In a state wherein PSA is interposed between two objects to be coupled, PSA acts to attach the two objects to each other upon receiving a predetermined pressure. PSA can achieve desired adhesive strength even under conditions of a room temperature and low pressure and therefore, has an advantage of realizing attachment of an object without deformation of the object. The adhesive member 162 is seated over the lined portion 172 of the photo-etched member 170, serving to attach the transparent member 161 and the photo-etched member 170 to each other.

After completion of the above described process, the pattern unit 160 is manually coupled to the casing member 113.

The PSA may have a single color or various colors. As occasion demands, only a part of the PSA may be colored. For this, the PSA may contain a colored material. The colored material may include a dye.

The PSA may be selected from various kinds of adhesives. In one example, the PSA may include an acryl-based adhesive. Assuming use of the acryl-based adhesive, the PSA has high transparency and light transmissivity. As occasion demands, a desired color of dye may be added into the PSA to provide the PSA with a color. The colored PSA is shaped into a sheet, serving to attach the transparent member 161 and the photo-etched member 170 to each other.

The PSA may be formed such that only a partial region thereof is colored to correspond to the pattern. In one example, when a flower-shaped pattern is formed on the photo-etched member 170, a partial region of the PSA may be red to express a color of a flower petal. The PSA is positioned to coincide with the pattern such that the red region of the PSA corresponds to the flower-shaped pattern of the photo-etched member 170. In a state wherein the transparent member 161 and the photo-etched member 170 are coupled to each other by use of the PSA, the red color of the flower-shaped pattern can be seen from the outside.

In another example, the entire PSA may be colored. When the pattern unit 160 is arranged on the cabinet 110 to decorate an external appearance of the cabinet 110, a color of the pattern unit 160 may be realized by the color of the PSA. Accordingly, controlling the color of the pattern unit 160 may arouse a user's aesthetic appreciation and purchase interest with respect to a product.

The PSA may be divided into a colorless portion and a colored portion. In other words, the PSA may include a colored portion (not shown) containing the dye, and a transparent portion (not shown) containing no dye. When the PSA is used to attach the transparent member 161 and the photo-etched member 170 to each other, the PSA is positioned such that the colored portion thereof corresponds to the pattern. As the colored portion of the PSA corresponds to the pattern, the pattern expresses the color of the PSA. The colored PSA may serve as an aid to arouse a user's aesthetic appreciation and purchase interest with respect to a product.

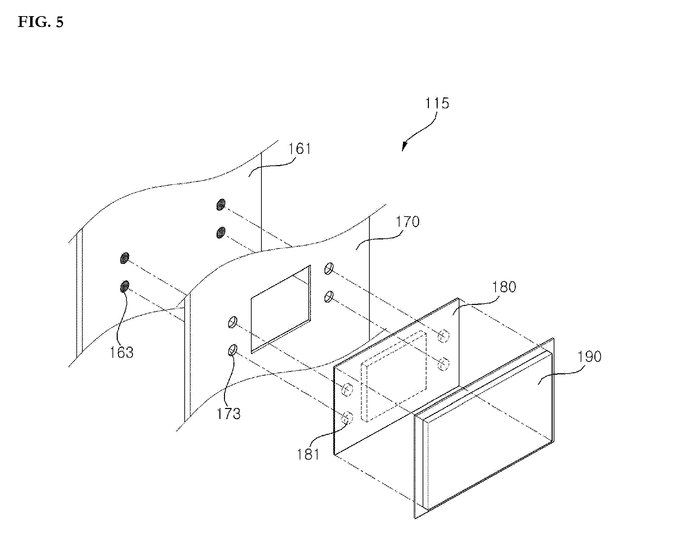

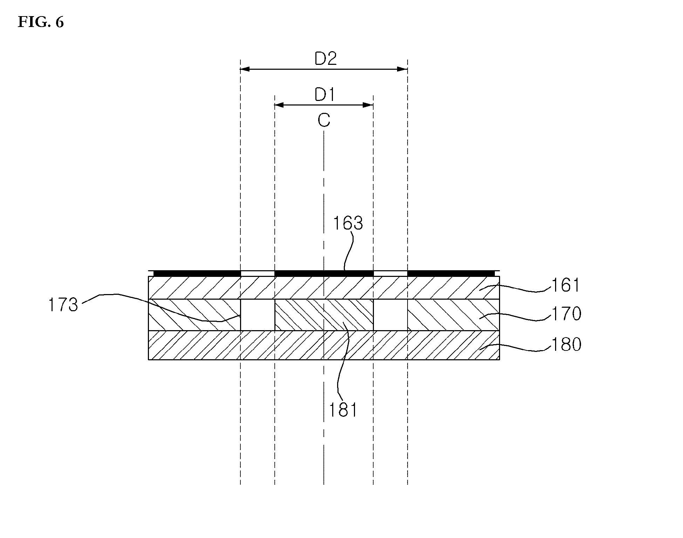

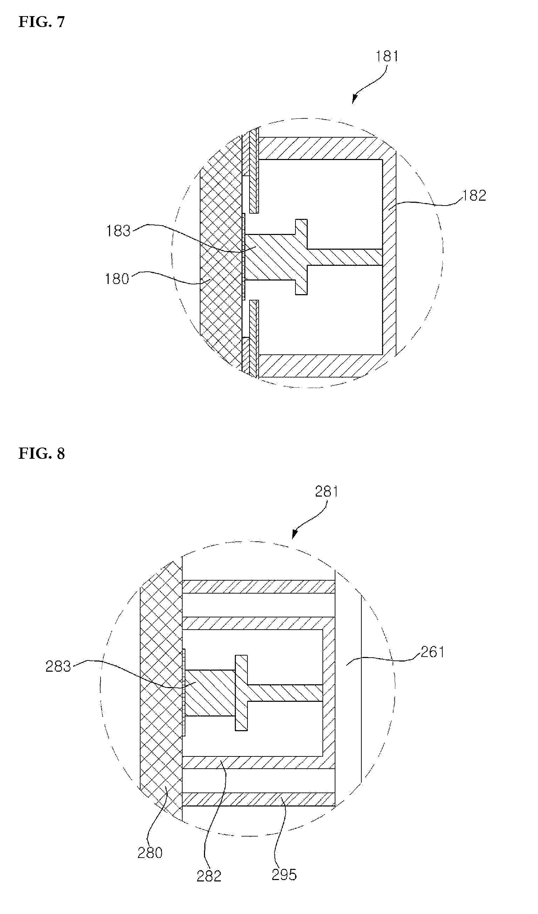

FIG. 4 is a front view showing the control panel 115 shown in FIG. 1. FIG. 5 is an exploded perspective view showing an assembly sequence of a touch pad unit 180 and the pattern unit 160 of the control panel 115. FIG. 6 is a sectional view showing a coupling relationship between the touch pad unit 180 and the pattern unit 160. FIG. 7 is a sectional view showing one embodiment of a sensor 181 shown in FIG. 6.

Referring to FIGs. 4 to 7, the pattern unit 160 serves to decorate an external appearance of the control panel 115. As described above, the pattern unit 160 includes the transparent member 161, and the photo-etched member 170 attached to a lower surface of the transparent member 161 by use of an adhesive, such as PSA.

The transparent member 161 includes indicators 163 to inform a user to touch regions. The indicators 163 may be printed with, e.g., symbols or icons that represent functions to be performed by a touch action.

The touch pad unit 180 includes sensors 181 to sense signals, a Printed Circuit Board (PCB) 190 to process signals from the sensors 181, and a display part 118 to output results of the signals processed by the PCB 190.

The sensors 181 may be arranged at different positions around the display part 118. In this case, functions and positions of the sensors 181 are irrespective of each other. In the present embodiment, the sensors 181 are arranged at opposite sides of the display part 118.

Now, operation of each sensor 181 will be described. First, to initiate a desired operation, the user is able to touch a corresponding one of the sensors 181. In this case, the user may directly touch the sensor 181, or may touch a predetermined position of the transparent member 161 corresponding to the sensor 181. The following description is based on the case of touching the transparent member 161. If the user touches the predetermined position of the transparent member 161, the corresponding sensor 181 has a variation in capacitance. The PCB 190 senses and processes the capacitance variation, thereby serving to operate the display part 118 or to operate the laundry treating machine 100.

The photo-etched member 170 is coupled to the touch pad unit 180. The photo-etched member 170 includes at least one touch pad hole 173 to correspond to the sensor 181. The transparent member 161 has the indicator 163 to inform the user of a touch region. The touch pad hole 173 may have an area larger than that of the indictor 163. The indicator 163 and the touch pad hole 173 may have a circular shape. In a state wherein the transparent member 161 and the photo-etched member 170 are stacked one above another, the indicator 163 and the touch pad hole 173 are aligned on approximately the same axis.

In the present embodiment, the indicator 163 and the touch pad hole 173 have a circular shape and are coaxially aligned on a center axis C. In this case, a diameter D1 of the indicator 163 may differ from a diameter D2 of the touch pad hole 173.

In one example, the diameter D1 of the indicator 163 may be smaller than the diameter D2 of the touch pad hole 173. In this case, the indicator 163 may be positioned in the interior region of the touch pad hole 173. This allows the sensor 181 to accurately sense a signal regardless of the region of the indicator 163 touched by the user. Preferably, the diameter D2 is greater than the diameter D1 by 2 mm or more, to assure a radial distance of 1 mm or more between the indicator 163 and the touch pad hole 173.

The photo-etched member 170 is made of stainless steel having high conductivity suitable for photo-etching. However, when the sensor 181 comes into contact with stainless steel, the sensor 181 may malfunction, resulting in deterioration in product reliability. To solve this problem, the photo-etched member 170 is formed with the touch pad hole 173 by cutting, and mirror printing for printing the touch regions on the transparent member 161 is performed while securing a gap between the touch pad hole 173 and the touch regions on the transparent member 161. This has the effect of preventing conduction due to the photo-etched member 170 and consequently, preventing malfunction of the sensor 181.

The sensor 181 may be configured such that an outer periphery thereof is spaced apart from an inner periphery of the touch pad hole 173 by a predetermined distance. The sensor 181 is inserted into the photo-etched member 170 from the bottom of the photo-etched member 170. In a state wherein the sensor 181 is completely inserted into the photo-etched member 170, the sensor 181 protrudes upward through the touch pad hole 173. That is, the sensor 181 is inserted through the touch pad hole 170, thereby coming into contact with the transparent member 161. The sensor 181 includes a light emitting element 182 to emit light, and a touch sensing element 183 to generate a signal in response of a user's touch action.

When the user touches the indicator 163, the touch sensing element 183 has a variation in capacitance. The PCB 190 senses and processes the capacitance variation of the touch sensing element 183. In this case, the user may touch an unintended portion rather than the indicator 163 by accident. That is, when the user touches an unintended portion rather than the indicator 163, the metallic pattern unit 160 exhibits movement of charges and consequently, has an electric potential, causing a variation in the capacitance of the touch sensing element 183. This may make the touch sensing element 183 to erroneously sense a signal due to the capacitance variation. Consequently, the PCB 190 may cause malfunction of the laundry treating machine 100 based on the erroneous signal.

To solve the above described problem, in the laundry treating machine 100 according to the present invention, the sensor 181 is spaced apart from the touch pad hole 173 by a predetermined distance. Accordingly, even if the user accidentally touches an unintended portion rather than the indicator 163, there occurs only a slight capacitance variation due to the photo-etched member 170. This may improve the accuracy of the sensor 181 and can prevent malfunction of the laundry treating machine 100.

FIG. 8 is a sectional view showing another embodiment of the sensor 181 shown in FIG. 6. The same reference numerals as those in the above described embodiment represent the same elements, and only differences from the above described embodiment will be described hereinafter.

Referring to FIG. 8, the laundry treating machine 100 further includes an insulator 295 provided between the touch pad hole 173 and a sensor 281. The insulator 295 may extend from a surface of a transparent member 261 so as to be inserted into the touch pad hole 173. The sensor 281 is also inserted into the touch pad hole 173 to come into contact with the transparent member 261.

The insulator 295 may be arranged around the sensor 281. Specifically, in a state wherein the sensor 281 is inserted into the touch pad hole 173, the insulator 295 is positioned between the sensor 281 and the touch pad hole 173. In this case, the insulator 295 is spaced apart from the sensor 281 by a predetermined distance. The insulator 295 may contain an insulating material. For example, the insulating material may include a polycarbonate sheet.

When the insulator 295 is arranged around the sensor 281, it is possible to prevent a variation in the capacitance of the sensor 281 due to an external electric field. In more detail, when the user touches an unintended portion of the transparent member 161 rather than the indicator 163, an electric potential may occur in the same manner as, or similar to the above description. Since the touch pad hole 173 is spaced apart from the sensor 281 by a predetermined distance, the sensor 281 is free from the capacitance variation due to the electric potential. However, if the sensor 281 sensitively reacts to the capacitance variation, malfunction of the laundry treating machine 100 may problematically occur. In this case, the insulator 295 may prevent the capacitance variation due to the electric potential. Specifically, even if the capacitance of the sensor 281 varies by the electric potential of the photo-etched member 170, the insulator 295 inserted in the touch pad hole 173 acts to completely insulate the sensor 281 from the photo-etched member 170. With the use of the insulator 295 for insulation of the sensor 281, no malfunction of the laundry treating machine 100 occurs even when the user touches an unintended portion of the transparent member 161 rather than the indicator 163 and consequently, it is possible to prevent an accident due to the malfunction of the laundry treating machine 100. In this way, reliability of the laundry treating machine 100 can be improved.

It will be understood by those skilled in the art that example embodiments can be implemented in other specific forms without changing the technical spirit or essential features of the present invention. Therefore, it should be noted that the forgoing embodiments are merely illustrative in all aspects and are not to be construed as limiting the invention. The scope of the invention is defined by the appended claims rather than the detailed description of the invention. All changes or modifications or their equivalents made within the meanings and scope of the claims should be construed as falling within the scope of the invention.

According to a home appliance and a washing treating machine of the present invention, as a result of providing an insulator around a sensor that is used to sense a user's touch action, there can be accomplished an effect of preventing malfunction of the home appliance or the washing machine even if a user touches an unintended portion rather than an indicator for initiation of a desired operation.

The effects of the present invention are not limited to the above-mentioned effects, and other effects not mentioned above can be clearly understood from the definitions in the claims by one skilled in the art.

## Claims

1. A home appliance comprising:
a touch pad unit having a sensor to sense an external capacitance variation;
a photo-etched member coupled to the touch pad unit and having a touch pad hole corresponding to the sensor, the photo-etched member having a pattern realized by photo-etching; and
a transparent member coupled to the photo-etched member so as to define an external appearance of the photo-etched member and having an indicator to inform a user of a touch region, the indicator having an area smaller than an area of the touch pad hole so as to be located in an interior region of the touch pad hole.

2. The home appliance of claim 1, wherein the sensor is inserted into the touch pad hole.

3. The home appliance of claim 2, further comprising an insulator inserted between the sensor and the touch pad hole.

4. The home appliance of claim 2, wherein the sensor comes into contact with a rear surface of the transparent member.

5. The home appliance of claim 3, wherein the insulator is spaced apart from the sensor by a predetermined distance.

6. The home appliance of claim 3, wherein the insulator includes an insulating material.

7. The home appliance of claim 3, wherein the insulator extends from the photo-etched member and is inserted into the touch pad hole.

8. The home appliance of claim 1, wherein the transparent member is made of reinforced glass.

9. The home appliance of claim 1, wherein the sensor includes:
a light emitting element to emit light; and
a touch sensing element to sense a signal generated by a user's touch action.

10. The home appliance of claim 1, wherein the indicator and the touch pad hole have a circular shape, and a radius of the indicator differs from a radius of the touch pad hole.

11. A washing machine comprising:
a touch pad unit having a sensor to sense an external capacitance variation;
a photo-etched member coupled to the touch pad unit and having a touch pad hole corresponding to the sensor, the photo-etched member having a pattern realized by photo-etching; and
a transparent member coupled to the photo-etched member so as to define an external appearance of the photo-etched member and having an indicator to inform a user of a touch region, the indicator having an area smaller than an area of the touch pad hole so as to be located in an interior region of the touch pad hole.

12. The washing machine of claim 11, wherein the sensor is inserted into the touch pad hole.

13. The washing machine of claim 12, further comprising an insulator inserted between the sensor and the touch pad hole.

14. The washing machine of claim 12, wherein the sensor comes into contact with a rear surface of the transparent member.

15. The washing machine of claim 11, wherein the indicator and the touch pad hole have a circular shape, and a radius of the indicator differs from a radius of the touch pad hole.
